# EUROPEAN PATENT APPLICATION

(11) **EP 1 206 006 A1**
(43) Date of publication of application: **15.05.2002**
(21) Application number: 00127502.3
(22) Date of filing: 15.12.2000
(51) Int. Cl.: H01R 12/04, H05K 3/36

(54) **Circuit board assembly**

(30) Priority: 13.11.2000 SE 0004161
(71) Applicant: Telefonaktiebolaget L M Ericsson (Publ), 126 25 Stockholm (SE)
(72) Inventor: Roos, Sture, 76010 Bergshamra (SE)
(74) Representative: Hammar, Ernst

(57) **Abstract**

The invention relates to a circuit board assembly and a method of connecting at least two circuit boards (10,20) together. A first circuit board (10) comprising a first slot (14) formed in said first circuit board (10) at its outer edge, which first circuit board (10) has a first set of conductive pads (16) formed adjacent to said first slot (14) and its extension (18) in said first circuit board (10), is connected together with a second circuit board (20) comprising a second slot (24) formed in said second circuit board (20) at its outer edge, which second circuit board (20) has a second set of conductive pads (26) formed adjacent to said second slot (24) and its extension (28) in said second circuit board (20). The first circuit board (10) is received in said second slot (24) formed in said second circuit board (20) and the second circuit board (20) is received in said first slot (14) formed in said first circuit board (10).

## Description

### TECHNICAL FIELD OF THE INVENTION

The invention relates to a circuit board assembly comprising at least two circuit boards connected together.

### DESCRIPTION OF RELATED ART

Circuit boards are often connected together in order to be able to send signals between the circuit boards. In applications within the telecommunication industry, particularly when cross-connecting a number of circuit boards, a high number of connections between the circuit boards is desirable in order to be able to send a lot of signals between the circuit boards at the same time.

Circuit boards are often connected to other circuit boards using interfacing terminals.

Another way of connecting circuit boards to other circuit boards is shown in US 5,321,585 A, which shows a connection between a main circuit board and an auxiliary circuit board without the use of interfacing terminals. The main circuit board has a slot formed therein and the auxiliary circuit board has a projection which is received in the slot of the main circuit board. Conductive pads are formed on both circuit boards at substantially right angles adjacent the intersection of the two circuit boards. A solder fillet is formed bridging the copper pads on each circuit board to provide electrical and mechanical connection.

Connecting circuit boards to each other using interfacing terminals has the following disadvantages: In the first place, the interfacing terminals are expensive and require numerous steps to attach them to the circuit boards thus adding to the assembly costs. Secondly, interfacing terminals are bulky which means that the number of possible connections between circuit boards is limited.

Connecting circuit boards to each other as shown in US 5,321,585 A has the following disadvantages: In the first place, it is not possible to arrange components on the projection on the auxiliary circuit board which projection is received in the slot of the main circuit board. Secondly, the number of possible connections between the circuit boards is limited.

### SUMMARY OF THE INVENTION

The object of the invention is to bring about a circuit board assembly with an increased number of connections between the circuit boards.

This is achieved by a circuit board assembly comprising a first circuit board comprising a first slot formed in said first circuit board at its outer edge, which first circuit board has a first set of conductive pads formed adjacent to said first slot and its extension in said first circuit board, and a second circuit board comprising a second slot formed in said second circuit board at its outer edge, which second circuit board has a second set of conductive pads formed adjacent to said second slot and its extension in said second circuit board, and where the first circuit board is received in said second slot formed in said second circuit board and where the second circuit board is received in said first slot formed in said first circuit board whereby each conductive pad of the first set aligns with a corresponding conductive pad of the second set, and where each conductive pad of the first set is electrically and mechanically connected with a corresponding conductive pad of the second set to make an electrical and mechanical connection between the first and second circuit boards.

The assembly according to the invention has the following advantages: no expensive interfacing members are needed and the number of connections between the circuit boards is increased.

### BRIEF DESCRIPTION OF THE DRAWINGS

The invention will be described in more detail below with reference to the appended drawings, wherein:
Fig. 1 is a schematic perspective view of two circuit boards before assembly in accordance with a preferred exemplary embodiment of the present invention,
Fig. 2 is a schematic perspective view of the circuit boards in Fig. 1 after assembly,
Fig. 3 is a schematic cross sectional view along line 3-3 of the circuit boards illustrated in Fig. 2, and
Fig. 4 is a schematic perspective view of another embodiment of the invention.

### DETAILED DESCRIPTION OF EMBODIMENTS

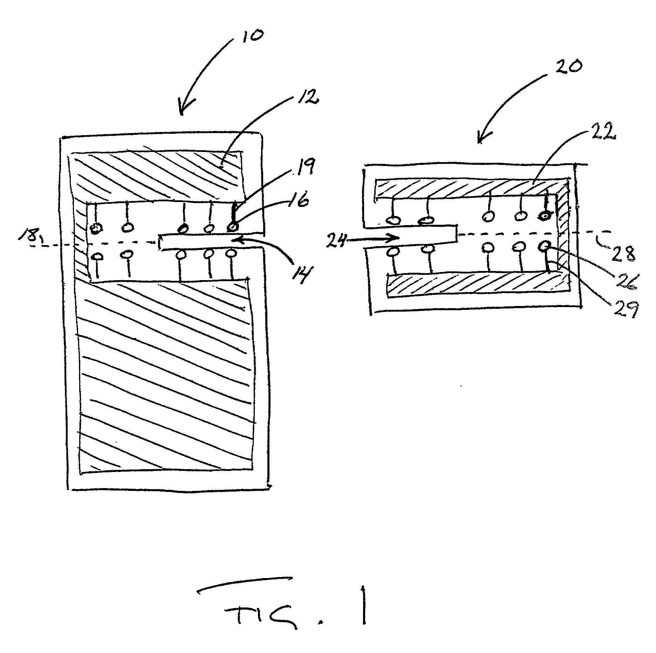

On the drawings, Fig. 1 illustrates in schematic perspective view two circuit boards 10, 20, before assembly, according to the present invention. A first circuit board 10 comprises a first electronic circuit board pattern 12 formed on said first circuit board 10, a first slot 14 formed in said first circuit board 10 at its outer edge, a first set of conductive pads 16 formed adjacent to said first slot 14 and its extension 18 in said first circuit board 10, and a conductive lead 19 extending from each of the conductive pads 16 of the first set to said first electronic circuit pattern 12. The circuit board assembly further comprises a second circuit board 20 comprising a second electronic circuit board pattern 22 formed on said second circuit board 20, a second slot 24 formed in said second circuit board 20 at its outer edge, a second set of conductive pads 26 formed adjacent to said second slot 24 and its extension 28 in said second circuit board 20, and a conductive lead 29 extending from each of the conductive pads 26 of the second set 26 to said second electronic circuit pattern 22.

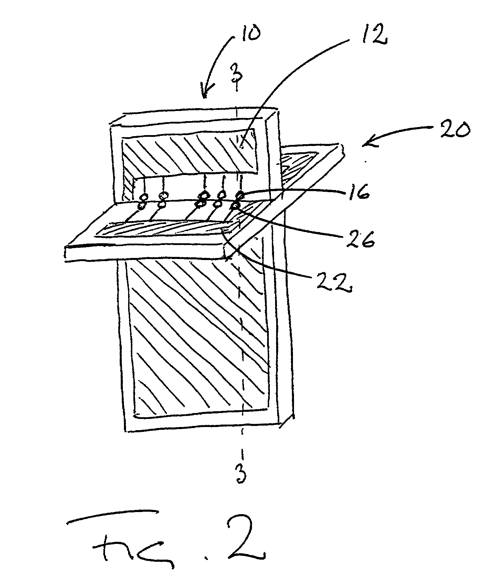

As shown in Fig. 2, the first circuit board 10 is received in said second slot 24 formed in said second circuit board 20 and the second circuit board 20 is received in said first slot 14 formed in said first circuit board 10 whereby each conductive pad 16 of the first set aligns with a corresponding conductive pad 26 of the second set. Each conductive pad 16 of the first set is electrically and mechanically connected with a corresponding conductive pad 26 of the second set to make an electrical and mechanical connection between the first and second circuit boards 10,20.

In this embodiment, the first and second electronic circuit board patterns 12, 22 are arranged on both sides of said first and second circuit boards 10, 20, respectively. It is also possible to arrange the electronic circuit board patterns 12, 22 on only one of the sides of said circuit boards 10, 20.

In this embodiment, the first slot 14 and second slot 24, respectively, reach from the outer edge of said first circuit board 10 to the centre of said first circuit board 10 and from the outer edge of said second circuit board 20 to the centre of said second circuit board 20, respectively. It is also possible to arrange slots 14, 24 that reach almost across the whole circuit board 10, 20 or e.g. both slots reaching only a short distance from the outer edge into the circuit boards 10, 20 as long as the first and second slots 14, 24 interact with the first and second circuit board 10, 20 in accordance with claim 1 of the present invention.

In this embodiment, conductive pads 16, 26 are arranged on both sides of both of said first and second circuit boards 10, 20 whereby the conductive pads 16, 26 advantageously transfer the stresses between the circuit boards 10, 20 without weakening the coupling between the first and second circuit boards 10, 20 as four contact "surfaces" are created between the first and second circuit boards 10, 20. The inherent strength associated with the circuit boards 10, 20 is utilized to provide a stable mechanical contact and a stable electrical contact. In this embodiment, as can be seen in Fig. 1, ten conductive pads 16, 26 are arranged on each side of both of the circuit boards 10, 20 thus summing up to twenty conductive pads 16, 26 on each circuit board 10, 20, respectively, of which not all are shown in Fig. 1. It is also possible to arrange more than ten or less than ten conductive pads 16, 26 on each side of the circuit boards 10, 20. It is also possible to arrange the conductive pads 16, 26 on fewer sides e.g. on both sides of at least one of said first and second circuit boards 10, 20 or on one side of both of said first and second circuit boards 10, 20 as long as the first and second conductive pads 16, 26 interact according to claim 1 of the present invention.

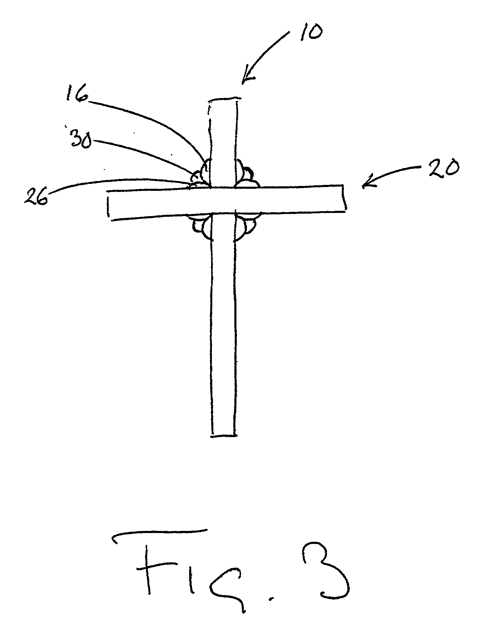

As illustrated in Fig. 3 the said first and second circuit boards 10, 20 are preferably arranged at substantially right angles to each other. It is also possible to arrange the circuit boards at an angle of 45°-135° to each other whereby a decrease in building height of the circuit board assembly is achieved.

Each conductive pad 16 of the first set is preferably electrically and mechanically connected by solder 30 with a corresponding conductive pad 26 of the second set to make an electrical and mechanical connection between the first and second circuit boards 10, 20. It is also possible to use other means of connection 30, e.g. glue.

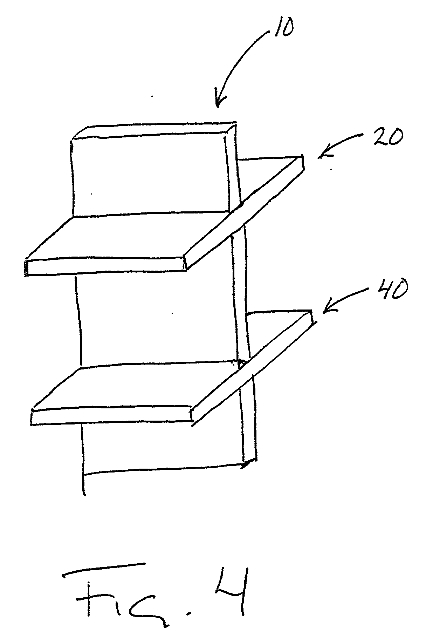

As shown in Fig. 4, it is also possible to connect at least one additional circuit board 40 to the first or second circuit board 10, 20 whereby a more complex cross connection of several circuit boards is achieved.

## Claims

1. A circuit board assembly comprising a first circuit board (10) comprising a first electronic circuit board pattern (12) formed on said first circuit board (10), a first slot (14) formed in said first circuit board (10) at its outer edge, a first set of conductive pads (16) formed adjacent to said first slot (14) and its extension (18) in said first circuit board (10), and a conductive lead (19) extending from each of the conductive pads (16) of the first set to said first electronic circuit pattern (12), the circuit board assembly further comprising a second circuit board (20) comprising a second electronic circuit board pattern (22) formed on said second circuit board (20), a second slot (24) formed in said second circuit board (20) at its outer edge, a second set of conductive pads (26) formed adjacent to said second slot (24) and its extension (28) in said second circuit board (20), and a conductive lead (29) extending from each of the conductive pads (26) of the second set to said second electronic circuit pattern (22), wherein the first circuit board (10) is received in said second slot (24) formed in said second circuit board (20) and that the second circuit board (20) is received in said first slot (14) formed in said first circuit board (10) whereby each conductive pad (16) of the first set aligns with a corresponding conductive pad (26) of the second set, and where each conductive pad (16) of the first set is electrically and mechanically connected with a corresponding conductive pad (26) of the second set to make an electrical and mechanical connection between the first and second circuit boards (10, 20).

2. A circuit board assembly according to claim 1, **characterized in, that** conductive pads (16, 26) are arranged on both sides of at least one of said first and second circuit boards (10, 20).

3. A circuit board assembly according to claim 2, **characterized in, that** conductive pads (16, 26) are arranged on both sides of both of said first and second circuit boards (10, 20).

4. A circuit board assembly according to one of the previous claims, **characterized in, that** said first and second circuit boards (10, 20) are arranged at substantially right angles to each other.

5. A circuit board assembly according to one of the previous claims, **characterized in, that** each conductive pad (16) of the first set is electrically and mechanically connected by solder (30) with a corresponding conductive pad (26) of the second set to make an electrical and mechanical connection between the first and second circuit boards (10, 20).

6. A circuit board assembly according to one of the previous claims, **characterized in, that** at least one additional circuit board (40) is connected to the first or second circuit board (10, 20).

7. A method of connecting a first circuit board (10) comprising a first electronic circuit board pattern (12) formed on said first circuit board (10), a first slot (14) formed in said first circuit board (10) at its outer edge, a first set of conductive pads (16) formed adjacent to said first slot (14) and its extension (18) in said first circuit board (10), and a conductive lead (19) extending from each of the conductive pads (16) of the first set to said first electronic circuit pattern (12), with a second circuit board (20) comprising a second electronic circuit board pattern (22) formed on said second circuit board (20), a second slot (24) formed in said second circuit board (20) at its outer edge, a second set of conductive pads (26) formed adjacent to said second slot (24) and its extension (28) in said second circuit board (20), and a conductive lead (29) extending from each of the conductive pads (26) of the second set to said second electronic circuit pattern (22) comprising the steps of:
- inserting the first circuit board (10) in said second slot (24) formed in said second circuit board (20),
- inserting the second circuit board (20) in said first slot (14) formed in said first circuit board (10),
- aligning each conductive pad (16) of the first set with a corresponding conductive pad (26) of the second set, and
- electrically and mechanically connecting each conductive pad (16) of the first set with a corresponding conductive pad (26) of the second set to make an electrical and mechanical connection between the first and second circuit boards (10, 20).

8. A method according to claim 7, where the step of electrically and mechanically connecting each conductive pad (16) of the first set with a corresponding conductive pad (26) of the second set comprises the step of:
- soldering each conductive pad (16) of the first set to a corresponding conductive pad (26) of the second set.

9. A method according to claim 7 or 8, comprising the step of connecting at least one additional circuit board (40) to the first or second circuit board (10, 20).

10. Use of a circuit board assembly according to one of claims 1-6 in a telecommunication system.
